# EUROPEAN PATENT APPLICATION

(11) **EP 1 516 854 A1**
(43) Date of publication of application: **23.03.2005**
(21) Application number: 03719132.7
(22) Date of filing: 17.04.2003
(51) Int. Cl.: C01G 1/00, C01G 3/00, C23C 14/08, C23C 14/28, H01L 39/24, H01B 12/06, H01B 13/00

(54) **PROCESS FOR PRODUCING OXIDE SUPERCONDUCTIVE THIN-FILM**

(30) Priority: 26.04.2002 JP 2002125380
(71) Applicant: SUMITOMO ELECTRIC INDUSTRIES, Ltd, Osaka-shi, Osaka 541-0041 (JP)
(72) Inventor: HAHAKURA, Shuji, c/o Sumitomo Electric Ind. Ltd., Osaka-shi, Osaka 554-0024 (JP); OHMATSU, Kazuya, c/o Sumitomo Electric Ind. Ltd., Osaka-shi, Osaka 554-0024 (JP)
(74) Representative: Kreutzer, Ulrich, Dipl.-Phys.
(86) International application number: PCT/JP2003/004932
(87) International publication number: WO 2003/091157

(57) **Abstract**

Provided is a method of producing an oxide superconducting film on a single-crystal substrate by depositing, on the single-crystal substrate, substances scattered from a raw material due to irradiation with laser beams according to a pulsed-laser deposition method, wherein the irradiation of the raw material is performed in a manner such that the repetition frequency of the pulse irradiation of the laser beams is divided into at least two steps. Thus, an oxide superconducting film having a high critical current density can be produced by the method.

## Description

### Technical Field

The present invention relates to methods of producing oxide superconducting films, and in particular, relates to methods of producing oxide superconducting films on single-crystal substrates by pulsed-laser deposition.

### Background Art

For example, a method of depositing a superconducting film on a single-crystal substrate by vapor deposition is described in the following document:

B. Schey, *et al*., "Large Area Pulsed Laser Deposition of YBCO Thin Films", IEEE TRANSACTIONS ON APPLIED SUPERCONDUCTIVITY, Vol. 9, No. 2, JUNE 1999, pp. 2359-2362.

In the method described in this document, a laser ablation process is used for forming a film. More specifically, an oxide superconducting film is formed on a substrate by depositing substances scattered from a target due to irradiation with a laser beam. The document states that a large area oxide superconducting film, such as a YBa₂Cu₃O₇₋ₓ(YBCO) film, can be formed by this method. However, since the conditions of a process for yielding a high critical current density were not established in the method described in this document, the oxide superconducting films formed by the method inevitably had a low critical current density.

### Disclosure of Invention

Accordingly, it is an object of the present invention to provide a method for producing an oxide superconducting film having a higher critical current density than that of known examples.

The method of the present invention for producing an oxide superconducting film is a method in which an oxide superconducting film is formed on a single-crystal substrate by depositing substances scattered from a raw material due to irradiation with laser beams according to a pulsed-laser deposition method, and which is characterized in that the irradiation of the raw material is performed in a manner such that the repetition frequency of the pulse irradiation of the laser beams (hereinafter referred to as a laser frequency) is divided into at least two steps. The laser used in the method may be an excimer laser, for example, ArF laser having a wavelength of 193 nm, KrF laser having a wavelength of 248 nm, or XeCl laser having a wavelength of 308 nm.

As a result of extensive investigations, the inventors have found that an oxide superconducting film produced by at least two steps of laser irradiations at different laser frequencies has a higher critical current density than an oxide superconducting film formed by one step of laser irradiation at a single laser frequency.

The process of forming an oxide superconducting film can generally be divided into two steps: a step of forming a seed crystal on the substrate surface and a step of growing the crystal. In the present invention, it is possible to divide laser frequencies into at least two steps: a frequency suitable for forming a seed crystal as a first step and another frequency suitable for growing the crystal as a second step. Accordingly, an oxide superconducting film having a high critical current density can be formed.

In the above-mentioned method of producing the oxide superconducting film, the first laser frequency is preferably smaller than the second laser frequency.

Thus, by controlling the laser frequency as described above, an oxide superconducting film having a higher critical current density can be produced.

In the above-mentioned method of producing the oxide superconducting film, the energy per pulse (hereinafter referred to as laser power) is preferably 400 mJ or more. By setting a laser power at such a level, an oxide superconducting film having a high critical current density can be produced.

In the above-mentioned method of producing the oxide superconducting film, the temperature of a substrate during the pulsed-laser deposition is preferably more than or equal to 600°C and less than 1,200°C. An oxide superconducting film having a high critical current density can be produced by setting the temperature of the substrate to such a level.

In the above-mentioned method of producing the oxide superconducting film, the gas pressure during the pulsed-laser deposition is within the range of 1.33 Pa to 100 Pa, and preferably from 1.33 Pa to 66.66 Pa. By setting the gas pressure at such a level, an oxide superconducting film having a high critical current density can be produced.

In the above-mentioned method of producing the oxide superconducting film, the atmosphere during the pulsed-laser deposition preferably contains oxygen. With such presence of oxygen, an oxide superconducting film having a high critical current density can be produced.

In the above-mentioned method of producing the oxide superconducting film, the oxide superconducting film preferably has an RE123 composition. The RE is a substance including at least one of a rare-earth element and yttrium. The oxide superconducting film having a RE123 composition, which can transport a high current, is suitable for an electric-power application.

The "RE123 composition" in the present specification is represented by REₓBa_{y}Cu_{z}O_{7-d}, where 0.7 ≤ x ≤ 1.3, 1.7 ≤ y ≤ 2.3, and 2.7 ≤ z ≤ 3.3. RE in the "RE123 composition" indicates a substance that includes at least one of a rare-earth element and yttrium.

### Brief Description of the Drawings

Figure 1 illustrates a method of producing an oxide superconducting film according to an embodiment of the present invention.
Figure 2 illustrates steps for forming an oxide superconducting film in two steps at different laser frequencies in a pulsed-laser deposition process.
Figure 3 is a cross-sectional view schematically showing a configuration of an oxide superconducting film according to an embodiment of the present invention.
Figure 4 shows the relationship between the gas pressure during pulsed-laser deposition and the critical current density of an HoBa₂Cu₃Oₓ (HoBCO) superconducting layer under a self-magnetic field in liquid nitrogen.

### Best Mode for Carrying Out the Invention

Embodiments according to the present invention will now be described with reference to drawings.

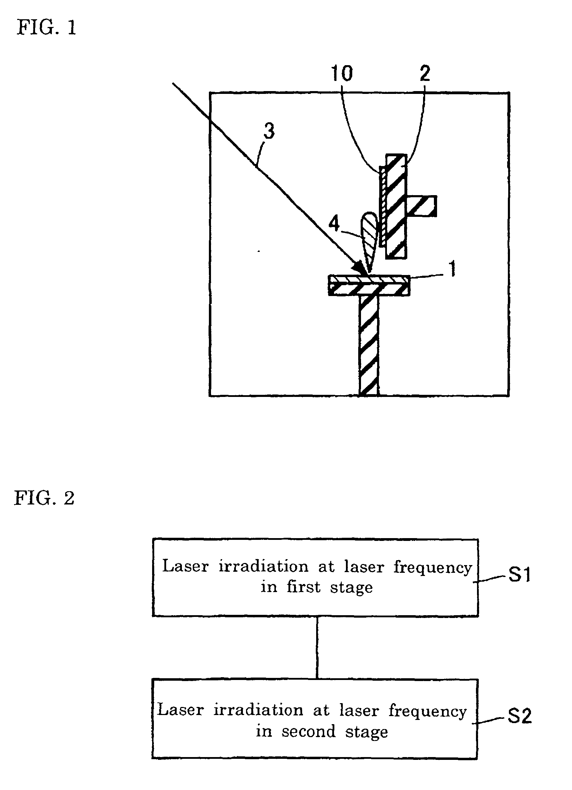

Figure 1 illustrates a method of producing an oxide superconducting film according to an embodiment of the present invention. With reference to Fig. 1, a substrate 10 is disposed on a heater 2 at a predetermined angle to a target (raw material) 1. With this arrangement, the substrate 10 is covered with a mask (not shown) at a predetermined area. The target 1 is irradiated with a laser beam 3 to perform laser ablation. A substance (plume) 4 scattered from the target 1 is vapor deposited on the exposed surface of the substrate 10 to form an oxide superconducting film.

The laser frequencies of the laser irradiation to the target 1 are different between the two steps (step S1 and step S2), as shown in Fig. 2. The laser frequency of the laser irradiation in the first step (step S1) is preferably smaller than that in the second step (step S2). The laser power of the laser irradiation is preferably at least 400 mJ, more preferably at least 600 mJ, and most preferably from 800 mJ to 1,000 mJ.

The temperature of the substrate 10 during the pulsed-laser deposition is preferably more than or equal to 600°C and less than 1,200°C, and more preferably more than or equal to 800°C and less than 1,200°C.

The gas pressure during the pulsed-laser deposition is preferably from 1.33 Pa to 66.66 Pa, and the atmosphere during the pulsed-laser deposition preferably contains oxygen.

In the above embodiment, two different laser frequencies are employed in the two steps, but three or more different laser frequencies may be used.

The oxide superconducting film formed by the above-mentioned method will now be described.

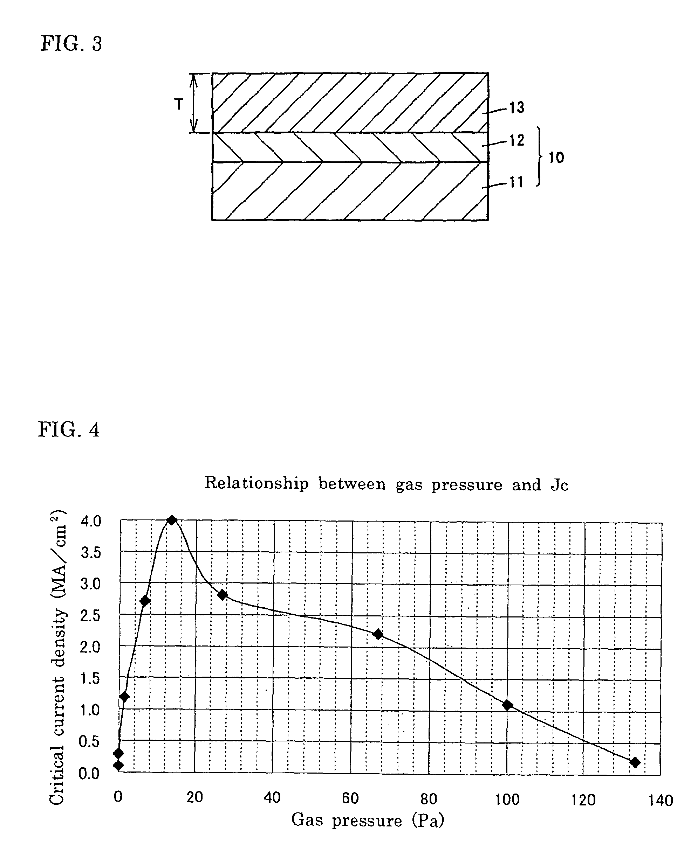

Figure 3 schematically shows a cross-sectional view of the configuration of an oxide superconducting film according to an embodiment of the present invention. With reference to Fig. 3, the oxide superconducting film 13 is formed on the substrate 10. The substrate 10 includes a single-crystal sapphire substrate 11 and an intermediate layer 12 composed of, for example, cerium oxide. The oxide superconducting film 13 is composed of, for example, HoBa₂Cu₃Oₓ and has a thickness T.

The oxide superconducting film 13 may be formed on the single-crystal sapphire substrate 11 directly.

Examples of the present invention will now be described.

### EXAMPLE 1

A holmium-based superconducting film (HoBa₂Cu₃Oₓ: HoBCO) was formed on a single-crystal substrate of lanthanum aluminate by a laser ablation process using a XeCl excimer laser having a wavelength of 308 nm. In this process, the repetition frequency of the laser irradiation was varied as a parameter. The film deposition was conducted at a repetition frequency of a first step for ten minutes, and thereafter at a repetition frequency of a second step for ten minutes. The atmosphere contained oxygen gas at 13.33 Pa, the temperature of the substrate was 900°C and the laser power was 900 mJ; these conditions were kept constant during the film deposition. To determine the characteristics of the superconducting layer, the critical current density of the HoBCO superconducting layer under a self-magnetic field in liquid nitrogen was measured. The results are shown in Table I.

**Table I.**

| Critical current density of HoBCO superconducting layer under self-magnetic field in liquid nitrogen at various repetition frequencies in first and second steps. | | | | | | |
|---|---|---|---|---|---|---|
| Frequency in first step (Hz) | Frequency in second step (Hz) | | | | | |
| | 1 | 5 | 20 | 40 | 100 | 200 |
| 1 | 0.9 | 1.9 | 3.0 | 2.8 | 1.5 | 1.3 |
| 5 | 0.4 | 0.7 | 3.0 | 4.0 | 3.2 | 1.8 |
| 20 | 0.3 | 0.4 | 0.8 | 2.0 | 1.8 | 1.5 |
| 40 | 0.2 | 0.3 | 0.4 | 0.8 | 1.2 | 1.2 |
| 100 | 0.1 | 0.1 | 0.3 | 0.3 | 0.6 | 1.2 |
| 200 | 0.0 | 0.1 | 0.1 | 0.2 | 0.3 | 1.1 |

As shown in Table I, in the cases where the repetition frequency of laser irradiation in the first step was smaller than that in the second step, the critical current density was high.

### EXAMPLE 2

A holmium-based superconducting film (HoBa₂Cu₃Oₓ: HoBCO) was formed on a single-crystal substrate of lanthanum aluminate by a laser ablation process. In this process, laser energy was varied as a parameter. The film deposition was conducted at a repetition frequency of 5 Hz for ten minutes in the first step, and thereafter at a repetition frequency of 40 Hz for ten minutes in the second step. The atmosphere contained oxygen gas at 13.3 Pa and the temperature of the substrate was 900°C; these conditions were kept constant during the film deposition. To determine the characteristics of the superconducting layer, the critical current density of the HoBCO superconducting layer under a self-magnetic field in liquid nitrogen was measured. The results are shown in Table II.

**Table II.**

| Critical current density of HoBCO superconducting layer under self-magnetic field in liquid nitrogen at various laser power levels. | | | | | | | | | |
|---|---|---|---|---|---|---|---|---|---|
| Laser power (mJ) | 200 | 300 | 400 | 500 | 600 | 700 | 800 | 900 | 1,000 |
| Critical current density of HoBCO superconducting layer (MA/cm²) | 0.2 | 0.3 | 1.5 | 2.3 | 2.8 | 3.4 | 3.6 | 4.0 | 3.8 |

As shown in Table II, in the ceases where the laser energy was 400 mJ or more, the critical current density was high.

### EXAMPLE 3

A holmium-based superconducting film (HoBa₂Cu₃Oₓ: HoBCO) was formed on a single-crystal substrate of lanthanum aluminate by a laser ablation process. In this process, the temperature of the substrate was varied as a parameter. The film deposition was conducted at a repetition frequency of 5 Hz for ten minutes in the first step, and thereafter at a repetition frequency of 40 Hz for ten minutes in the second step. The atmosphere contained oxygen gas at 13.3 Pa and the laser power was 900 mJ; these conditions were kept constant during the film deposition. To determine the characteristics of the superconducting layer, the critical current density of the HoBCO superconducting layer under a self-magnetic field in liquid nitrogen was measured. The results are shown in Table III.

**Table III.**

| Critical current density of superconducting layer under self-magnetic field in liquid nitrogen at various substrate temperatures. | | | | | | | | |
|---|---|---|---|---|---|---|---|---|
| Substrate temperature (°C) | 400 | 500 | 600 | 800 | 900 | 1,000 | 1,100 | 1,200 |
| Critical current density of HoBCO (MA/cm²) | 0.1 | 0.3 | 1.8 | 3.1 | 4.0 | 3.8 | 3.5 | 0.3 |

As shown in Table III, in the cases where the temperature of the substrate was more than or equal to 600°C and less than 1,200°C, the critical current density was high.

### EXAMPLE 4

A holmium-based superconducting film (HoBa₂Cu₃Oₓ: HoBCO) was formed on a single-crystal substrate of lanthanum aluminate by a laser ablation process. In this process, oxygen-gas pressure during the film deposition was varied as a parameter. The film deposition was conducted at a repetition frequency of 5 Hz for ten minutes in the first step, and thereafter at a repetition frequency of 40 Hz for ten minutes in the second step. The temperature of the substrate was 900°C and the laser power was 900 mJ; these conditions were kept constant during the film deposition. To determine the characteristics of the superconducting layer, the critical current density of the HoBCO superconducting layer under a self-magnetic field in liquid nitrogen was measured. The results are shown in Table IV and Fig. 4.

**Table IV.**

| Critical current density of HoBCO superconducting layer under self-magnetic field in liquid nitrogen at various gas pressures. | | | | | | | | | |
|---|---|---|---|---|---|---|---|---|---|
| Gas pressure (Pa) | 0.07 | 0.13 | 1.33 | 6.67 | 13.33 | 26.66 | 66.66 | 100 | 133.3 |
| Critical current density of HoBCO (MA/cm²) | 0.1 | 0.3 | 1.2 | 2.7 | 4.0 | 2.8 | 2.2 | 1.1 | 0.2 |

As shown in Table IV and Fig. 4, the critical current density was high in the cases where the gas pressure was within a range of 1.33 Pa to 100 Pa, and especially within the range of 1.33 Pa to 66.66 Pa.

### EXAMPLE 5

A holmium-based superconducting film (HoBa₂Cu₃Oₓ: HoBCO) was formed on a single-crystal substrate of lanthanum aluminate by a laser ablation process. In this process, the type of atmospheric gas during the film deposition was varied as a parameter. The film deposition was conducted at a repetition frequency of 5 Hz for ten minutes in the first step, and thereafter at a repetition frequency of 40 Hz for ten minutes in the second step. The temperature of the substrate was 900°C, the laser power was 900 mJ and the atmospheric gas pressure was 13.33 Pa; these conditions were kept constant during the film deposition. To determine the characteristics of the superconducting layer, the critical current density of the HoBCO superconducting layer under a self-magnetic field in liquid nitrogen was measured. The results are shown in Table V.

**Table V.**

| Critical current density of HoBCO superconducting layer under self-magnetic field in liquid nitrogen in various types of gas. | | | | | |
|---|---|---|---|---|---|
| Type of gas | Argon | Oxygen | Hydrogen | Nitrogen dioxide | Dinitrogen monoxide |
| Critical current density of HoBCO (MA/cm²) | 0.1 | 4.0 | 0.2 | 0.3 | 0.3 |

As shown in Table V, when the gas was oxygen, the critical current density was high.

The embodiments and examples are intended merely as exemplifications of the present invention in all aspects and do not limit the scope of the present invention. The scope of the present invention is defined by the claims not by the above-mentioned descriptions. The scope of the present invention encompasses every alternative equivalent to or within the scope of the claims.

### Industrial Applicability

As described above, a method of producing an oxide superconducting film of the present invention includes at least two steps, in which a first laser frequency that is suitable for a seed-crystal-forming process and a second laser frequency that is suitable for a crystal-growing process are used. This results in forming an oxide superconducting film having a high critical current density.

## Claims

1. A method of producing an oxide superconducting film on a single-crystal substrate by depositing, on the single-crystal substrate, substances scattered from a raw material due to irradiation with laser beams according to a pulsed-laser deposition method, wherein the irradiation of the raw material is performed in a manner such that the repetition frequency of the pulse irradiation of the laser beams is divided into at least two steps.

2. A method of producing an oxide superconducting film according to claim 1, wherein the laser frequency of a first step is smaller than the laser frequency of a second step.

3. A method of producing an oxide superconducting film according to claim 1 or 2, wherein the laser power is 400 mJ or more.

4. A method of producing an oxide superconducting film according to any one of claims 1 to 3, wherein the temperature of the single-crystal substrate during the pulsed-laser deposition is more than or equal to 600°C and less than 1,200°C.

5. A method of producing an oxide superconducting film according to any one of claims 1 to 4, wherein the gas pressure during the pulsed-laser deposition is within the range of 1.33 Pa to 100 Pa.

6. A method of producing an oxide superconducting film according to any one of claims 1 to 4, wherein the gas pressure during the pulsed-laser deposition is within the range of 1.33 Pa to 66.66 Pa.

7. A method of producing an oxide superconducting film according to any one of claims 1 to 6, wherein the atmosphere during the pulsed-laser deposition contains oxygen.

8. A method of producing an oxide superconducting film according to any one of claims 1 to 7, wherein the oxide superconducting film comprises an RE123 composition, where RE is composed of at least one of a rare-earth element and yttrium.

## Amended claims

### Amended claims under Art. 19.1 PCT

**1.** (Amended) A method of producing an oxide superconducting film on a single-crystal substrate by depositing, on the single-crystal substrate, substances scattered from a raw material due to irradiation with laser beams according to a pulsed-laser deposition method, wherein the irradiation of the raw material is performed in a manner such that the repetition frequency of the pulse irradiation of the laser beams is divided into at least two steps, the laser frequency of a second step being higher than the laser frequency of a first step and less than 100 times the laser frequency of the first step.

**2.** (Amended) A method of producing an oxide superconducting film according to claim 1, wherein the laser frequency of the second step is not less than 2 times and not more than 40 times as high as the laser frequency of the first step in a case where the laser frequency of the first step is greater than or equal to 1 Hz and less than 20 Hz; and the laser frequency of the second step is not less than 2 times and not more than 5 times as high as the laser frequency of the first step in the case where the first laser frequency is 20 Hz.

**3.** A method of producing an oxide superconducting film according to claim 1 or 2, wherein the laser power is 400 mJ or more.

**4.** A method of producing an oxide superconducting film according to any one of claims 1 to 3, wherein the temperature of the single-crystal substrate during the pulsed-laser deposition is more than or equal to 600°C and less than 1,200°C.

**5.** A method of producing an oxide superconducting film according to any one of claims 1 to 4, wherein the gas pressure during the pulsed-laser deposition is within the range of 1.33 Pa to 100 Pa.

**6.** A method of producing an oxide superconducting film according to any one of claims 1 to 4, wherein the gas pressure during the pulsed-laser deposition is within the range of 1.33 Pa to 66.66 P

**7.** A method of producing an oxide superconducting film according to any one of claims 1 to 6, wherein the atmosphere during the pulsed-laser deposition contains oxygen.

**8.** A method of producing an oxide superconducting film according to any one of claims 1 to 7, wherein the oxide superconducting film comprises an RE123 composition, where RE is composed of at least one of a rare-earth element and yttrium.

Statement under Art. 19.1 PCT
To Claim 1 disclosing a method of producing an oxide superconducting film by laser deposition, the feature, i.e., "the laser frequency of a second step being higher than the laser frequency of a first step and less than 100 times the laser frequency of the first step", is introduced to clarify that an oxide superconducting film having a high critical current density can be produced by this method,

To Claim 2, the feature, i.e., "the laser frequency of the second step is not less than 2 times and not more than 40 times as high as the laser frequency of the first step in a case where the laser frequency of the first step is greater than or equal to 1 Hz and less than 20 Hz; and the laser frequency of the second step is not less than 2 times and not more than 5 times as high as the laser frequency of the first step in the case where the first laser frequency is 20 Hz", is introduced to clarify that an oxide superconducting film having a higher critical current density can be produced by this method.

In contrast, Cited Document (Japanese Unexamined Patent Application Publication No. 4-212214) discloses a laser deposition method (laser ablation method) in which the deposition rate is set low during the initial stage and increased afterward, and an example in which the first laser frequency is 1 Hz and the second laser frequency is 100 Hz.

The present invention relates to laser frequencies of laser beams used in laser deposition. By regulating the laser frequency of the second step with respect to the laser frequency of the first step, a superconducting film having a high critical current density, which has not been achievable with conventional products, can be produced.

The amendment made to the present invention is based on Table 1 of Example 1 in the specification and does not introduce any new matter. Moreover, Cited Document does not suggest the effect and advantage of the present invention. Thus, it would not have been easy for persons skilled in the art to conceive the present invention. The present invention has both novelty and inventive step.
